# EUROPÄISCHE PATENTSCHRIFT

(11) **EP 2 596 145 B1**
(45) Veröffentlichungstag und Bekanntmachung des Hinweises auf die Patenterteilung: **06.07.2016**
(21) Anmeldenummer: 11746453.7
(22) Anmeldetag: 22.07.2011
(51) Int. Cl.: C23C 14/50

(54) **VORRICHTUNG UND VERFAHREN ZUR VAKUUMBESCHICHTUNG**
DEVICE AND METHOD FOR VACUUM COATING
DISPOSITIF ET PROCÉDÉ DE DÉPÔT SOUS VIDE

(30) Priorität: 28.07.2010 DE 102010032591; 23.07.2010 DE 102010032152
(43) Veröffentlichungstag der Anmeldung: 29.05.2013
(73) Patentinhaber: Bühler Alzenau GmbH, 63755 Alzenau (DE)
(72) Erfinder: SCHMAUDER, Torsten, 63329 Egelsbach (DE); KERN, Günter, 63485 Bruchköbel (DE)
(74) Vertreter: Pohlmann, Bernd Michael
(86) Internationale Anmeldenummer: PCT/EP2011/003679
(87) Internationale Veröffentlichungsnummer: WO 2012/010318

(56) Entgegenhaltungen:
- DE-A1- 4 010 663
- GB-A- 1 321 486
- JP-A- 2009 228 062
- US-A1- 2003 085 123

## Beschreibung

Die Erfindung betrifft eine Vorrichtung sowie ein Verfahren jeweils nach den Oberbegriffen der unabhängigen Patentansprüche.

Systeme zur Vakuumbeschichtung von Substraten im Batch-Betrieb sind bekannt. So beschreiben beispielsweise die DE 37 31 688A1 oder EP 1 947 211 A1 jeweils eine Vorrichtung zur Metallisierung von Substraten mit einer Vakuumkammer, in der zumindest eine Verdampferquelle, sowie - in beiden Schriften jeweils verschieden gestaltete - Vorrichtungen zum Aufbringen von plasmapolymerisierten Schutzschichten und eine Anzahl von um eine Zentralachse rotierenden Planenten - Substrathaltern angeordnet sind. Mit diesen bekannten Systemen ist wegen des hohen Raumbedarfs der Substrathalter nur eine relativ lange Chargenzeit im Bereich größer 10 Minuten zu erreichen.

Aus dem Dokument GB 1 321 486 A ist eine Vorrichtung zur Vakuumbeschichtung bekannt, bei der eine Verdampferbank und Substratträgereinrichtungen gegenläufig zueinander bewegt werden. Dazu sind Planetengetriebe notwendig. Ferner führen die gegenläufigen Drehbewegungen von Verdampferbank und Substratträgereinrichtungen zu Polyzykloidenbewegungen der Substrate. Die einzelnen Substrate, vorzugsweise dreidimensionale Substrate, beispielsweise für Anwendungen im Automotivbereich, Computer-Kommunikation oder Konsumerelektrik, erreichen damit nur kurze Verweilzeiten im durch die Verdampferbank erzeugten Beschichtungsdampf - sowohl Substrat als auch Verdampfer drehen sich relativ schnell zu einander. Dabei ist zu berücksichtigen, dass eine Beschichtung nur bei sichtkontakt zwischen dem Verdampfer und dem zu bedampfenden Substrat erfolgt. Aufgrund der kurzen Verweilzeiten der Substrate sind daher relativ viele Umläufe und damit eine lange Chargenzeit und niedrige Produktivität die Folge.

Batch-Anlagen mit deutlich kürzerer Chargenzeit sind ebenfalls bekannt - etwa 4-5 Minuten bei Sputter-Anlagen des Typs PylonMet der Anmelderin. Nachteil ist hier der recht große technische Aufwand für die Ausrüstung mit Sputter-Quellen.

Aufgabe der vorliegenden Erfindung ist es, eine Vorrichtung und ein Verfahren anzugeben, bei dem mit geringem Aufwand metallischen Schichten auf Substrate mit hoher Qualität, kurzer Chargenzeit und hoher Produktivität aufgebracht werden können.

Die Aufgabe wird mit dem Merkmal der unabhängigen Patentansprüche gelöst. Vorteilhafte Ausführungsformen sind den abhängigen Ansprüchen zu entnehmen.

Die erfindungsgemäße Vorrichtung zur Vakuumbeschichtung von Substraten in einer Vakuumkammer mit einer lang gestreckten Verdampferbank mit einer Anzahl von entlang einer vertikalen Längsachse angeordneten thermischen Verdampferelementen und einer der Verdampferbank zugeordneten ersten Substratträgereinrichtung mit einem um eine erste Achse drehbaren ersten Pylon mit Halterungsmitteln für Substrate, wobei zwischen Längsachse und erster Drehachse ein Winkelversatz von weniger als 10° besteht, zeichnet sich dadurch aus, dass zumindest eine zweite der Verdampferbank zugeordnete Substratträgereinrichtung mit einem um eine zweite Achse drehbaren zweiten Pylon mit Halterungsmitteln für Substrate vorgesehen ist, wobei die Drehachsen der Pylone relativ zur Längsachse der Verdampferbank feststehend sind und eine geometrische Konfiguration der Verdampferbank sowie der ersten und der zumindest zweiten Substratträgereinrichtung derart vorgesehen ist, dass eine mittels der Verdampferbank erfolgende Beschichtung von Substraten der ersten und der zumindest zweiten Substratträgereinrichtung mit gleicher Qualität erfolgen kann. Der Ausdruck vertikal bezieht sich auf die Vakuumkammer als Bezugssystem. Der Ausdruck Qualität bezieht sich auf Parameter der Eigenschaften der Beschichtung, insbesondere eine Schichtdicke, einen Reflexionsfaktor und/oder einen Farbeindruck. Die räumliche Orientierung der Verdampferelemente relativ zu den Drehachsen der Pylone ist statisch. Die Verdampferbank rotiert nicht um ihre Längsachse; ebenso rotieren auch die Substratträgereinrichtungen nicht um die Verdampferbank. Falls zwischen Längsachse und der Verdampferbank und den Drehachsen Jeweils ein Winkelversatz von weniger 10° besteht, kann auf einfache Weise ein gleichartige geometrische Konfiguration der Vorrichtung erreicht werden, so dass die mittels der Verdampferbank erfolgende Beschichtung der Substrate mit gleicher oder zumindest ähnlicher Qualität erfolgt. Die erste und zumindest zweite Substratträgereinrichtung sind hierzu unter Beachtung der räumlichen Abstrahlcharakteristik der einzelnen Verdampferelemente sowie der Verdampferbank als ganzer relativ zur Verdampferbank an geometrisch äquivalenten Positionen angeordnet. Unter Abstrahlcharakteristik eines Verdampferelements wird hier die Winkelabhängigkeit der Stromdichte des verdampften Materials eines in die Verdampferbank eingebauten verstanden.

Die erfindungsgemäße Vorrichtung zur Vakuumbeschichtung von Substraten ermöglicht eine besonders kompakte Ausführung der Anlage und Ausnutzung des mittels der Verdampferbank erzeugten Beschichtungsdampfes, da die zumindest zwei Substratträgereinrichtungen Pylone mit feststehenden Achsen aufweisen. Die Erfindung umfasst auch den Fall von mehr als zwei Pylonen. Falls zwischen Längsachse und der Verdampferbank und den Drehachsen jeweils ein Winkelversatz von weniger 10° besteht, kann auf einfache Weise ein gleichartige geometrische Konfiguration der Vorrichtung erreicht werden, so dass die mittels der Verdampferbank erfolgte Beschichtung der Substrate mit gleicher oder zumindest ähnlicher Qualität erfolgt. Insbesondere sind Vakuumkammer, Verdampferbank und zugeordnete Substratträgereinrichtungen so ausgelegt, dass eine kurze Chargenzeit in einem Bereich zwischen vier und acht Minuten erreicht wird. Insbesondere handelt es sich bei den Substraten um dreidimensionale Substrate, beispielsweise für Anwendungen im Automotive-Bereich, Computer-Kommunikation- oder Konsumer-Elektronik, insbesondere aus Kunststoffmaterial, aber auch aus Metallmaterial oder Glas, die teilweise auch in relativ kleinen Chargen bestellt werden.

Mit der Erfindung kann eine hohe Produktivität des Beschichtungsprozesses trotz relativ kleiner Chargen, d. h. gleichzeitig zu beschichtender Werkstücke erreicht werden.

Eine weitere Ausführungsform der Erfindung zeichnet sich dadurch aus, dass die Verdampferbank zumindest ein Verdampferelement mit einer horizontalen Längserstreckung und einer zu einer durch die Längserstreckung und Längsachse aufgespannten Ebene spiegelsymmetrischen Abstrahlcharakteristik aufweist, wobei sich der Ausdruck horizontal auf die Vakuumkammer als Bezugssystem bezieht. Am einfachsten lässt sich dies mit einem zwischen Verdampferhalterungen eingespannten Verdampferelement, beispielsweise einem Metallfilament oder einer Metallwendel erreichen. Eine erste Verdampferhalterung haltert das Verdampferelement im Bereich einer Endseite; eine zweite Verdampferhalterung haltert das Verdampferelement im Bereich der zweiten Endseite. Die Befestigung der ersten und der zweiten Endseite an der ersten Halterung bzw. zweiten Halterung sind geometrisch gleichartig, so dass die Abstrahlcharakteristik symmetrisch zu einer Achse ist, die durch die Längserstreckung des Verdampferelements verläuft.

Es versteht sich, dass üblicherweise eine Mehrzahl von Verdampferelementen die erwähnte spiegelsymmetrische Abstrahicharakteristik aufweist. Im Fall einer ersten und einer zweiten Substratträgereinrichtung sind die Verdampferelemente vorteilhaft zwischen den einander gegenüberliegenden Substratträgereinrichtungen angeordnet. Im Fall von vier Substratträgereinrichtungen sind diese vorteilhaft in einer Konfiguration eines Quadrates angeordnet.

Eine weitere Ausführungsform der Erfindung zeichnet sich dadurch aus, dass zumindest eine der ersten oder der gegebenenfalls weiteren Substratträgereinrichtungen zugeordnete Behandlungsquelle vorgesehen ist. Falls die Behandlungsquelle eine Verdampferbank beinhaltet, kann die Produktivität der Vorrichtung in Bezug auf die Vakuumbeschichtung mittels thermischer Verdampfung erhöht werden. Falls sich bei der Behandlungsquelle von einer Verdampferbank verschiedener Quelle handelt, kann auf einfache Weise eine Hybrid-Vakuumbeschichtung der Substrate erfolgen.

Insbesondere sind die Verdampferelemente entlang einer vertikalen Längsachse angeordnet und es ist eine der ersten Substratträgereinrichtung zugeordnete Plasmaquelle vorgesehen, die so angeordnet ist, dass die Plasmabehandlung auf die erste Substratträgereinrichtung gerichtet ist. Ferner ist kann vorgesehen sein, dass auf der der ersten Substratträgereinrichtung abgewandten Seite der Verdampferbank eine zweite Substratträgereinrichtung mit einem um eine zweite Achse drehbaren zweiten Pylon mit Halterungsmitteln für Substrate und eine der zweiten Substratträgereinrichtung zugeordnete zweite Plasmaquelle, die so angeordnet ist, dass die zweite Substratträgereinrichtung durch die zweite Plasmaquelle in äquivalenter Weise behandelt wird, wie die erste Substratträgereinrichtung durch die erste Plasmaquelle..

Eine weitere Ausführungsform der Erfindung zeichnet sich dadurch aus, dass die Vakuumkammer eine erste Teilkammer mit einer Öffnung in der Wandung der Vakuumkammer, eine zweite, der ersten Teilkammer türartig zugeordnete Teilkammer, mit der die Öffnung vakuumdicht verschließbar ist, aufweist, wobei die Verdampferbank, die erste und zumindest zweite Substratträgereinrichtung und gegebenenfalls vorzugsweise zumindest Komponenten der Behandlungsquelle bzw. der Behandlungsquellen in der zweiten Teilkammer unterbringbar sind oder untergebracht sind. Die zweite Teilkammer ist relativ zur ersten Teilkammer positionierbar, sodass Verdampferbank und erste und zumindest zweite Substratträgereinrichtung leicht zugänglich und damit das Handling, insbesondere die Bestückung der Verdampferelemente mit Verdampfungsmaterial und die Beschickung der Substratträgereinrichtungen mit Substraten erleichtert ist. Zweckmäßigerweise ist vorgesehen, dass die zweite Teilkammer mittels einer Schwenkeinrichtung relativ zur ersten Teilkammer positionierbar ist oder das die zweite Teilkammer mittels einer Schiebereinrichtung relativ zur ersten Teilkammer positionierbar ist, womit einer Anpassung an räumliche Bedingungen der Installation der erfindungsgemäßen Vorrichtung zur Vakuumbeschichtung möglich ist.

Eine weitere Ausführungsform der Erfindung zeichnet sich dadurch aus, dass die Vakuumkammer eine analog der zweiten Teilkammer ausgebildete, der ersten Teilkammer türartig zugeordnete weitere Teilkammer aufweist, mit der die Öffnung der ersten Teilkammer vakuumdicht verschließbar ist, sodass ein alternierender Betrieb der Vorrichtung mit zweiten Teilkammer und der weiteren Teilkammer möglich ist. In dem alternierenden Betrieb wird jeweils eine der Teilkammern derart positioniert, dass die Öffnung vakuumdicht verschlossen ist, während die jeweils andere Tellkammer derart positioniert ist, dass die in ihr untergebrachte Verdampferbank und die Substratträgereinrichtungen zugänglich sind. Mittels der Teilkammer, die die Öffnung der ersten Tellkammer vakuumdicht verschließt, kann eine Vakuumbeschichtung von Substraten in der Vakuumkammer erfolgen, während die andere Teilkammer geöffnet positioniert ist und beispielsweise zum Handling von Verdampferbank und Substratträgereinrichtung zur Verfügung steht.

Das erfindungsgemäße Verfahren zur Vakuumbeschlchtung von Substraten zeichnet sich dadurch aus, dass die Vakuumbeschichtung mittels einer erfindungsgemäßen Vorrichtung erfolgt.

Eine Ausführungsform des erfindungsgemäßen Verfahrens zeichnet sich dadurch aus, dass mittels der Verdampferbank eine thermische Verdampfung eines metallischen Materials, insbesondere eines Materials aus zumindest einem der Mitglieder der Gruppe, wie Aluminium, Kupfer, Zinn, Zink, Chrom, Titan, Tantal, Silber, Gold, Rhodium, Palladium oder Nickel umfasst, erfolgt, und damit kostengünstig Metallisierungen von insbesondere dreidimensionalen Substraten vorgenommen werden können.

Eine weitere Ausführungsform der Erfindung zeichnet sich dadurch aus, dass sie mittels zumindest einer der Behandlungsquellen eine Behandlung der Substrate mit Hilfe einer Glimmentladung erfolgt, mit dem insbesondere eine Vorbehandlung der Substrate vor der Beschichtung erfolgen kann.

Eine weitere Ausführungsform des Verfahrens zeichnet sich dadurch aus, dass mittels der Behandlungsquelle eine Behandlung der Substrate mit Hilfe eines Plasma-CVD-Prozesses erfolgt, insbesondere zur Aufbringung einer Top Coat-Schicht auf metallisierte Substratoberflächen.

Im Folgenden wird die Erfindung anhand von Ausführungsbeispielen und Bezeichnungen näher beschrieben, denen auch unabhängig von der Zusammenfassung in den Patentansprüchen weitere Aspekte und Vorteile der Erfindung zu entnehmen sind.

Es zeigen in schematischer Darstellung:

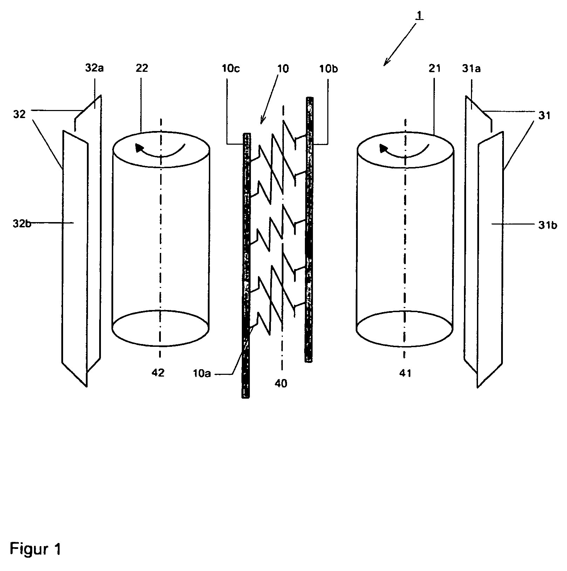

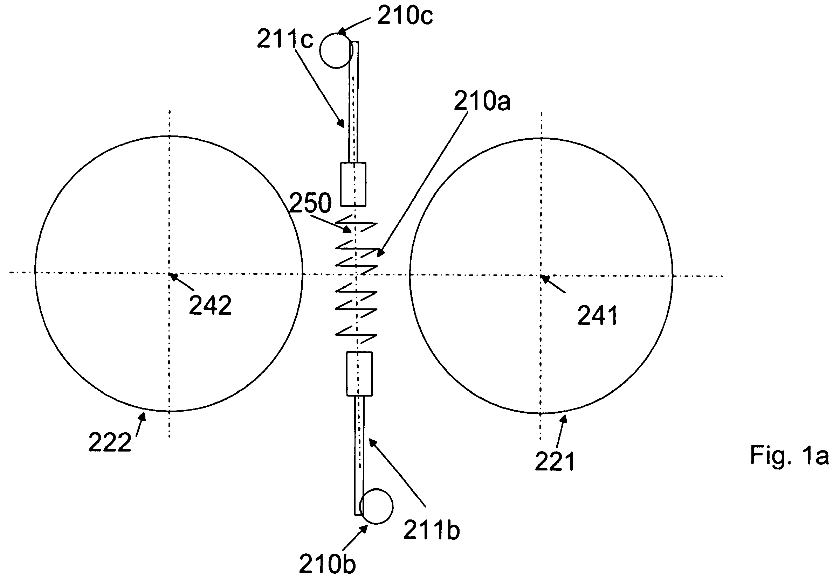

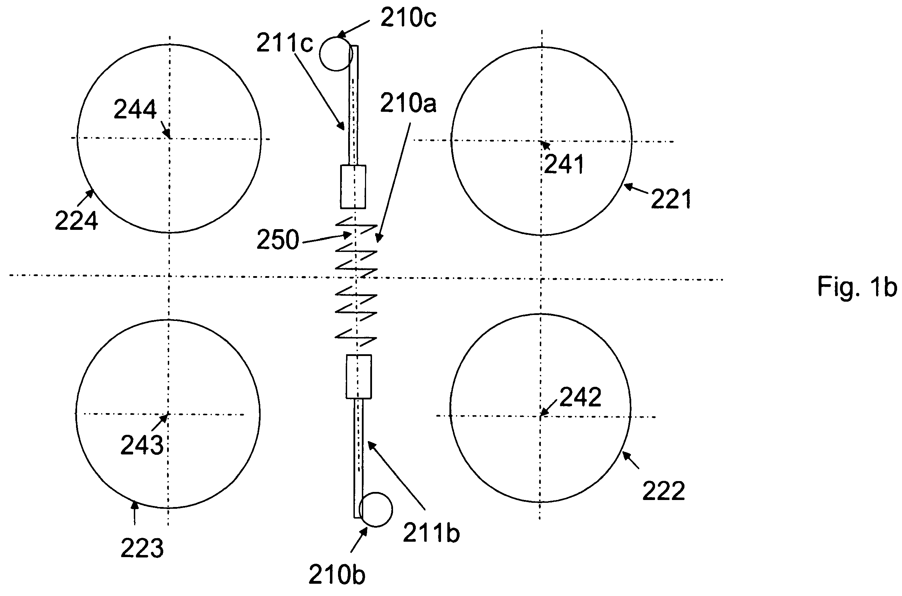

Figur 1 eine Darstellung der erfindungsgemäßen Vorrichtung zur Vakuumbeschichtung von Substraten mit einer Verdampferbank, zwei Substratträgereinrichtungen und zwei Plasmaquellen
Figur 1 a eine Darstellung der erfindungsgemäßen Vorrichtung zur Vakuumbeschichtung von Substraten mit einer Verdampferbank und zwei Substratträgereinrichtungen mit einer in eine Einspannhalterung eingespannten Verdampferwendel
Figur 1b eine Darstellung der erfindungsgemäßen Vorrichtung zur Vakuumbeschichtung von Substraten mit einer Verdampferbank und vier Substratträgereinrichtungen mit einer in einer Einspannhalterung eingespannten Verdampferwendel
Figur 2 eine Schnittdarstellung einer erfindungsgemäßen Vorrichtung mit einer ersten Teilkammer sowie zwei der ersten Teilkammer türartig zugeordneten weiteren Teilkammern.

In Figur 1 ist in vereinfachter Darstellung eine Vorrichtung 1 zur Vakuumbeschichtung von Substraten in einer Vakuumkammer, vorzugsweise dreidimensionalen Substraten beispielsweise für Anwendungen im Automotive-Bereich, Computer, Kommunikation- oder Konsumer-Elektronik oder dergleichen dargestellt. Die Substrate bestehen vorzugsweise aus einem Kunststoffmaterial, wobei jedoch auch andere Materialien vorstellbar sind. Die Vorrichtung 1 umfasst, neben nicht dargestellten Komponenten wie insbesondere Anschlüssen für Pumpen und Zuführeinrichtungen für Prozessgase, eine lang gestreckte Verdampferbank 10 mit einer Anzahl von entlang einer Längsachse 40 angeordneten Verdampferelementen 10a, die beispielsweise harfenartig in einer rahmenartigen Konstruktion mit lang gestreckten Trägerelementen 10b, 10c angeordnet sind. Die Verdampferelemente 10a können beispielsweise über eine Länge von 150 cm bis 200 cm Länge angeordnet sein, wobei zwischen den Trägerelementen 10b, 10c beispielsweise ein Abstand zwischen 20 und 30 cm vorgesehen sein kann. Die Verdampferelemente 10a können beispielsweise zum thermischen Verdampfen ausgelegt sein, insbesondere als zwischen den Trägerelementen 10b, 10c geeignet eingespannte Metallfilamente oder Metallwendel mit horizontaler Symmetrieachse ausgebildet sein. Bevorzugt ist die Befüllung der Verdampferelemente mit Aluminiumdraht. Bei Erwärmung, beispielsweise als Ergebnis eines Durchleitens eines elektrischen Stroms verdampft das Metall, so dass Metalldämpfe aus dem Bereich der Verdampferbank austreten und in den umgebenden Raum diffundieren und sich auf den Werkstücken niederschlagen.

Die Vorrichtung 1 umfasst ferner eine erste Substratträgereinrichtung 21, die um eine antreibbare Drehachse 41 drehbar ist und als Pylon, dass heißt als säulenartige Gerüststruktur ausgebildet ist. In Figur 1 sind zur Vereinfachung keine weiteren Details der Substratträgereinrichtung 21 sowie auch keine von der Einrichtung 21 aufgenommenen Substrate dargestellt. Die Drehachse 41 ist vorzugsweise parallel zur Längsachse 40 ausgerichtet, wobei es sich versteht, dass auch eine Ausrichtung von Drehachse 41 und Längsachse 40 mit einem geringen Winkelversatz, beispielsweise von weniger als 10° von der Erfindung umfasst ist.

Ferner umfasst die Vorrichtung 1 eine zweite Substratträgereinrichtung 22 mit einer Drehachse 42, die analog zur Substratträgereinrichtung 21 ausgebildet ist. Die Drehachse 42 ist, analog zur Drehachse 41, parallel oder mit einem geringen Winkelversatz von weniger als 10 Grad zur Längsachse 40 ausgerichtet. Die Drehachsen 41, 42 sind relativ zur Längsachse 40 feststehend

Es versteht sich, dass die Erfindung auch Vorrichtungen mit mehr als zwei Substratträgereinrichtungen umfasst, jeweils mit einem Pylon mit Halterungsmitteln für Substrate, wobei zwischen Längsachse der Verdampferbank und den Drehachsen der Pylone ein Winkelversatz von weniger als 10⁰ vorgesehen ist.

Ferner umfasst die Erfindung Substratträgereinrichtungen, die Planeten-Halterungsmittel für Substrate aufweisen, die um von der Drehachse, um die der Pylon drehbar ist, verschiedene Drehachsen drehbar sind.

Die Vorrichtung 1 umfasst ferner als Plasmaquellen 31, 32 ausgebildete Behandlungsquellen für Substrate. Die Plasmaquellen 31, 32 umfassen Mittel zur Anregung einer Plasmaentladung in einem Bereich, in dem die Substratträgereinrichtungen 21, 22 angeordnet sind, um eine Plasmabehandlung der Substrate zu ermöglichen. Die Behandlungsquellen, insbesondere Plasmaquellen können zur Vorbehandlung der Substratoberflächen und/ oder zu Plasmabeschichtung, insbesondere mittels Plasma -CVD ausgebildet sein. Insbesondere kann ferner ein Einlass für Reaktionsgase vorgesehen sein.

Bei der in Figur 1 dargestellten Ausführungsform umfasst die Plasmaquelle 31 eine Elektrode 31 a und eine Gegenelektrode 31 b sowie einen (nicht dargestellten) geerdeten Vakuumbehälter zur Erzeugung eines Plasmas, insbesondere einer Glimmentladung zur Behandlung einer zu behandelnden Oberfläche eines oder mehrerer Substrate. Die Elektroden 31 a, 31 b sind plattenartig mit einer im Wesentlichen parallel zur Drehachse 41 lang gestreckten Geometrie ausgelegt. Ferner zeigt Fig. 1 analoge Elektrode 32a und Gegenelektrode 32b der der Substrathalterungseinrichtung 22 zugeordneten Plasmaquelle 32. Bevorzugt werden die Plasmaquellen 31, 32 mit einer Wechselspannung betrieben, insbesondere einer Frequenz zwischen 1 Hz und 350 MHz, besonders bevorzugt bei 40 kHz.

Es versteht sich, dass die Erfindung auch weitere Ausbildungen, sowie eine weitere Anzahl von Behandlungsquellen umfasst, insbesondere zur Ausführung eines Plasma-CVD-Prozesses ausgebildete Plasmaquellen, mit denen beispielsweise ein Top-Coat auf eine Metallschicht aufgebracht werden kann. Ferner versteht es sich, dass die Erfindung auch für bestimmte Behandlungen der Substrate dedizierte, getrennte Plasmaquellen umfasst. Ferner kann auch eine der Behandlungsquellen für mehr als einen Behandlungsprozess, beispielsweise Glimmentladung und PECVD vorgesehen sein.

Die Dimensionierung der Verdampferbank 10 sowie der Behandlungsquellen 31, 32 in Richtung der Drehachsen 41, 42 ist abgestimmt zur Kompensation von räumlichen Endeffekten, d.h. im vorliegenden Fall durch einen gewissen Überstand von Verdampferbank 1 D bzw. Behandlungsquelle 31, 32 über die Endbereiche der Substratträgereinrichtung 21, 22. Ferner kann ein Abfall bspw. einer Beschichtungsrate in den Endbereichen der Verdampferbank 10 bzw. der Substratträgereinrichtungen 21, 22 durch eine entsprechend Einstellung des Abstandes der Verdampferelemente 10a voneinander entlang der Längsachse 40 kompensiert werden. Es können jedoch auch andere Maßnahmen zur Kompensation von räumlichen Endeffekten vorgesehen sein, beispielsweise Blenden in einem mittleren Bereich zwischen den Endbereichen.

Figur 1a zeigt in vereinfachter Darstellung eine Schnittansicht einer Ausführungsform der Erfindung mit einer Verdampferbank und zwei spiegelsymmetrisch zu einer Längserstreckung 250 eines Verdampferelements 210a angeordneten Substratträgereinrichtungen 221, 222, welche jeweils um ihre Längsachsen 241, 242 rotieren. Die Verdampferbank besteht aus zwei Trägerelementen 210b, 210c an denen jeweils mindestens eine Verdampferhalterung 211b, 211c angebracht ist, die das Verdampferelement 210a hält. Die horizontale Längserstreckung 250 des Verdampferelements 210a entspricht der horizontalen Längserstreckung der Verdampferbank 10.

Figur 1b zeigt in vereinfachter Darstellung eine Schnittansicht einer Ausführungsform der Erfindung mit vier spiegelsymmetrisch zu einer Längserstreckung 250 eines Verdampferelements 210a bzw. punktsymmetrisch zum Mittelpunkt des Verdampferelements 210a angeordneten Substratträgereinrichtungen 221, 222, 223, 224, welche jeweils um ihre Längsachsen 241, 242, 243, 244 rotieren.

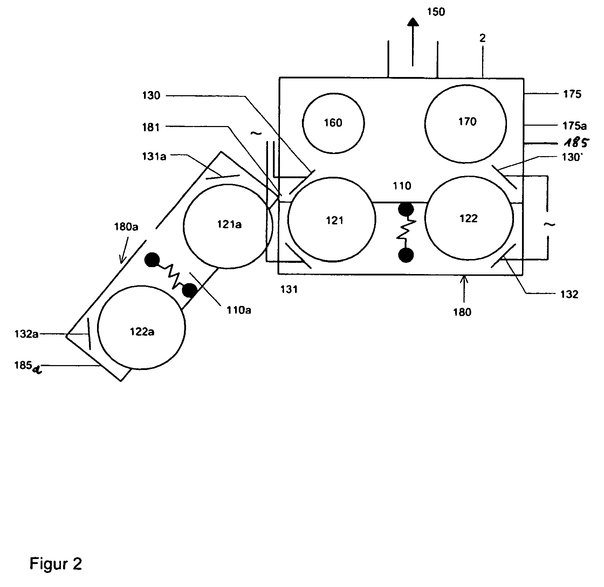

Figur 2 zeigt eine Schnittdarstellung einer weiteren Ausführungsform der Erfindung mit einer Vorrichtung 2, welche eine Vakuumkammer 175, die eine erste Teilkammer 175a, eine zweite Teilkammer 180 und eine weitere Teilkammer 180a umfasst, beinhaltet. Die Teilkammer 175a weist eine Öffnung der Wandung 185 auf, die von der zweiten Teilkammer 180 vakuumdicht verschließbar ist. Die zweite Teilkammer 180a kann ebenfalls die Öffnung vakuumdicht verschließen. Die Teilkammern 180 und 180a sind türartig ausgebildet. Mittels einer Schwenkeinrichtung kann die Teilkammer 180 sowie die Teilkammer 180a relativ zur Teilkammer 175a positioniert werden. Für die Teilkammer 180a ist in Figur 2 eine Schwenkachse 181 dargestellt, um die die Teilkammer 180a zum Öffnen der Öffnung schwenkbar ist. Eine entsprechende Schwenkachse ist für die Teilkammer 180 vorgesehen. Es versteht sich, dass die Teilkammern 180 und 180a alternierend geöffnet und geschlossen werden können und dass die entsprechenden Türanschläge entgegengesetzt zueinander orientiert sind.

Die Teilkammer 180 umfasst eine Verdampferbank 110 sowie Substratträgereinrichtungen 121, 122, analog wie in Figur 1 dargestellt. Ferner umfasst die Teilkammer 180 Elektroden 131, 132, die der Substrathaltereinrichtung 121 bzw. 122 jeweils zugeordnet sind und zusammen mit der Teilkammer 180 schwenkbar sind. Eine weitere Elektrode 130 bzw. 130' ist in der Teilkammer 175a angeordnet, so dass die Elektroden 130, 131 bzw. 130', 132 jeweils ein Elektrodenpaar bilden. Im geschlossenen Zustand ermöglichen die Elektroden 130, 131, bzw. 130', 132 die Ausbildung eines Plasmas, mit dem eine Behandlung von in den Substrathalterungen 121, 122 angeordneten Substraten erfolgen kann.

Figur 2 zeigt ferner eine verschwenkte Teilkammer 180a, die Substratträgereinrichtungen 121a, 122a sowie Elektroden 131a, 132a aufweisen. Zwischen den Substratträgern 121a, 122a ist in der Teilkammer 180a eine Verdampferbank 110a angeordnet. Die Teilkammer 180a kann um die Schwenkachse 181 geschwenkt werden, um die Öffnung der Wandung 185 der Teilkammer 175a zu verschließen, wobei es sich versteht, dass die Teilkammer 180 zuvor entsprechend positioniert wurde, um die Öffnung in der Wandung 185 freizugeben. Im geschlossenen Zustand ist bei verschwenkter Teilkammer 180a durch die Wandung 185a und die Wandung 185 eine durchgehende, insbesondere vakuumdichte Wandung realisierbar.

Durch die Zweiteilung der Behandlungsquellen 31, 32 wird die Wartungszeit zwischen den Beschichtungsvorgängen deutlich verkürzt, indem sich die Türen in einem einzigen Arbeitsschritt öffnen bzw. schließen lassen und alle gegebenenfalls zu wartenden oder auszutauschenden Komponenten (Trägerelemente 10a, 10b, 10c, Substrate) in den Türen angeordnet sind,

Ferner ist ein Anschluss 150 für eine Prozesspumpe für Prozesse mit Gasanfall vorgesehen, der vorzugsweise symmetrisch bezüglich der Substratträgereinrichtung 121, 122 angeordnet ist, um gleiche Vakuumverhältnisse in den Bereichen der Substratträgereinrichtungen 121, 122 zu gewährleisten. Es versteht sich, dass auch nicht symmetrische Anordnungen des Anschluss 150 von der Erfindung umfasst werden.

Die Vorrichtung 2 weist im Bereich der Teilkammer 175a Anschlüsse für zumindest eine Hochvakuumpumpe, insbesondere eine Diffusionspumpe, vorzugsweise eine Öldiffusionspumpe, sowie eine Vorrichtung zur Wasserdampfentfemung, vorzugsweise einer Wasser pumpenden Kaltefalle, auf. Es versteht sich, dass die Teilkammer 175a neben den Komponenten 160, 170 weitere nicht näher dargestellt Steuermittel umfasst.

### Bezugszeichenliste

- 1: Vorrichtung
- 2: Vorrichtung
- 10: Verdampferbank
- 10a: Verdampferelement
- 10b: Trägerelement
- 10c: Trägerelement
- 21: Substratträgereinrichtung
- 22: Substratträgereinrichtung
- 31: Behandlungsquelle
- 31a: Elektrode
- 31b: Gegenelektrode
- 32: Behandlungsquelle
- 32a: Elektrode
- 32b: Gegenelektrode
- 40: Längsachse
- 41: Längsachse einer Substratträgereinrichtung
- 42: Längsachse einer Substratträgereinrichung
- 110: Verdampferbank
- 110a: Verdampferbank
- 121: Substrathaltereinrichtung
- 121a: Substrathaltereinrichtung
- 122: Substrathaltereinrichtung
- 122a: Substrathaltereinrichtung
- 130: Elektrode
- 130': Elektrode
- 131: Gegenelektrode
- 131a: Gegenelektrode
- 132: Gegenelektrode
- 132a: Gegenelektrode
- 150: Anschluss
- 160: Steuermittel
- 170: Steuermittel
- 175: Vakuumkammer
- 175a: Erste Teilkammer
- 180: Zweite Teilkammer
- 180a: Weitere Teilkammer
- 181: Schwenkachse
- 185: Wandung
- 185a: Wandung
- 210a: Verdampferelement
- 210b: Trägerelement
- 210c: Trägerelement
- 211a: Verdampferhalterung
- 211b: Verdampferhalterung
- 221: Substratträgereinrichtung
- 222: Substratträgereinrichtung
- 223: Substratträgereinrichtung
- 224: Substratträgereinrichtung
- 241: Längsachse einer Substratträgereinrichtung
- 242: Längsachse einer Substratträgereinrichtung
- 243: Längsachse einer Substratträgereinrichtung
- 244: Längsachse einer Substratträgereinrichtung
- 250: Horizontale Längserstreckung

## Patentansprüche

1. Vorrichtung zur Vakuumbeschichtung von Substraten in einer Vakuumkammer (175) mit einer langgestreckten Verdampferbank (10, 110, 110a) mit einer Anzahl von entlang einer vertikalen Längsachse (40) angeordneten Verdampferelementen (10a, 210a) und einer der Verdampferbank (10, 110, 110a) zugeordneten ersten Substratträgereinrichtung (21, 121, 221) mit einem um eine erste Drehachse (41, 241) drehbaren ersten Pylon mit Halterungsmitteln für Substrate, wobei zwischen Längsachse (40) und erster Drehachse (41, 241) ein Winkelversatz von weniger als 10° besteht, **dadurch gekennzeichnet, dass** zumindest eine zweite der Verdampferbank (10, 110, 110a) zugeordnete Substratträgereinrichtung (22, 122, 222) mit einem um eine zweite Drehachse (42, 242) drehbaren zweiten Pylon mit Halterungsmitteln für Substrate vorgesehen ist, wobei die Achsen der Pylone relativ zur Längsachse (40) der Verdampferbank (10, 110, 110a) feststehend ausgebildet sind, die Verdampferbank (10, 110, 110a) nicht um ihre Längsachse rotiert und die Substratträgereinrichtungen (21, 121, 221, 22, 122, 222) nicht um die Verdampferbank (10, 110, 110a) rotieren und zwischen Längsachse (40) und zweiter Drehachse (42, 242) ein Winkelversatz von weniger als 10° besteht und eine geometrische Konfiguration der Verdampferbank (10, 110, 110a) sowie der ersten (21, 121, 221) und der zumindest zweiten Substratträgereinrichtung (22, 122, 222) derart vorgesehen ist, dass eine mittels der Verdampferbank (10) erfolgende Beschichtung von Substraten der ersten (21, 121, 122) und der zumindest zweiten Substratträgereinrichtung (22, 122, 222) mit gleicher Qualität erfolgen kann.

2. Vorrichtung nach Anspruch 1, **dadurch gekennzeichnet, dass** die Verdampferbank (10) zumindest ein Verdampferelement (10a, 110, 110a) mit einer horizontalen Längserstreckung (250) und einer zu einer durch die Längserstreckung (250) und Längsachse (40) aufgespannten Ebene spiegelsymmetrischen Abstrahlcharakteristik aufweist.

3. Vorrichtung nach Anspruch 1 oder 2, **dadurch gekennzeichnet, dass** zumindest eine der ersten (21, 121, 221) oder gegebenenfalls weiteren Substratträgereinrichtungen (22, 122, 222, 223, 224) zugeordnete Behandlungsquelle (31, 32) vorgesehen ist.

4. Vorrichtung nach einem der Ansprüche 1 bis 3, **dadurch gekennzeichnet, dass** die Vakuumkammer (175)
- eine erste Teilkammer (175a) mit einer Öffnung in der Wandung 185 der Vakuumkammer (175),
- zumindest eine zweite, der ersten Teilkammer türartig zugeordnete Teilkammer (180, 180a), mit der die Öffnung vakuumdicht verschließbar ist, aufweist,
wobei die Verdampferbank (110), die erste (121) und die zumindest zweite Substratträgereinrichtung (122) und der Behandlungsquelle oder Behandlungsquellen (31, 32) in der zumindest zweiten Teilkammer unterbringbar oder untergebracht sind.

5. Vorrichtung nach Anspruch 4, **dadurch gekennzeichnet, dass** die zweite Teilkammer (180) mittels einer Schwenkeinrichtung oder mittels einer Schiebeeinrichtung relativ zur ersten Teilkammer (175a) positionierbar ist.

6. Vorrichtung nach einem der Ansprüche 4 bis 5, **dadurch gekennzeichnet, dass** die Vakuumkammer (175) eine analog der zweiten Teilkammer (180) ausgebildete, der ersten Teilkammer türartig zugeordnete weitere Teilkammer (180a) aufweist, mit der die Öffnung der ersten Teilkammer vakuumdicht verschließbar ist.

7. Vorrichtung nach einem der Ansprüche 3 bis 6, **dadurch gekennzeichnet, dass** zumindest eine Behandlungsquelle (31, 32) als Plasmaquelle mit zumindest einem Elektrodenpaar (31a/b, 32a/b, 130/131, 130/131a, 130'/132, 130'/132a), vorzugsweise zumindest eine plattenartige Elektrode beinhaltend, ausgebildet ist.

8. Vorrichtung nach Anspruch 7, **dadurch gekennzeichnet, dass** zumindest eine Elektrode (130, 130') zumindest eines Elektrodenpaares in der ersten Teilkammer und zumindest eine zugeordnete Gegenelektrode (131, 131a, 132, 132a) des zumindest einen Elektrodenpaars in der zweiten Teilkammer (180, 180a) angeordnet ist, wobei die Gegenelektrode (131, 131a, 132, 132a) zusammen mit der zweiten Teilkammer (180, 180a) relativ zur ersten Tellkammer (175a) positionierbar ist.

9. Vorrichtung nach einem der Ansprüche 3 bis 8, **dadurch gekennzeichnet, dass** die Dimensionierung der Verdampferbank (10) sowie gegebenenfalls der Behandlungsquellen (31, 32) zur Kompensation von räumlichen Endeffekten einen Überstand von Verdampferbank (10) sowie gegebenenfalls der Behandlungsquellen (31, 32) über die Endbereiche der Substratträgereinrichtungen (21, 22) aufweist.

10. Vorrichtung nach einem der vorhergehenden Ansprüche, **dadurch gekennzeichnet, dass** ein Abstand der Verdampferelemente (10a) voneinander zum Kompensieren eines Abfalls einer Beschichtungsrate in den Endbereichen der Verdampferbank (10, 110, 110a) oder der Substratträgereinrichtungen (21, 22) einstellbar ist.

11. Verfahren zur Vakuumbeschichtung von Substraten, **dadurch gekennzeichnet, dass** die Vakuumbeschichtung mittels einer Vorrichtung nach einem der vorhergehenden Ansprüche erfolgt.

12. Verfahren nach Anspruch 11, **dadurch gekennzeichnet, dass** mittels der Verdampferbank (10, 110, 110a) eine thermische Verdampfung eines metallischen Materials aus zumindest einem der Mitglieder der Gruppe, die Aluminium, Kupfer, Zinn, Chrom, Titan, Tantal, Gold, Silber, Rhodium, Palladium oder Nickel umfasst, erfolgt.

13. Verfahren nach einem der Ansprüche 11 oder 12, dadurch gekennzeicttnet, dass mittels zumindest einer der Behandlungsquellen (31, 32) eine Behandlung der Substrate mit Hilfe eines Glimmentladungsprozesses erfolgt.

14. Verfahren nach einem der Ansprüche 11 bis 13, **dadurch gekennzeichnet, dass** mittels zumindest einer der Behandlungsquellen (31, 32) eine Behandlung der Substrate mit Hilfe eines Plasma-CVD-Prozesses erfolgt.

## Claims

1. Device for the vacuum coating of substrates in a vacuum chamber (175), comprising an elongate evaporator array (10, 110, 110a) having a number of evaporator elements (10a, 210a) arranged along a vertical longitudinal axis (40) and a first substrate carrier unit (21, 121, 221) which is associated with the evaporator array (10, 110, 110a) and has a first pylon that can be rotated about a first rotation axis (41, 241) and has holding means for substrates, wherein there is an angular offset of less than 10° between the longitudinal axis (40) and the first rotation axis (41, 241), **characterized in that** at least a second substrate carrier unit (22, 122, 222) is provided, which is associated with the evaporator array (10, 110, 110a) and has a second pylon that can be rotated about a second rotation axis (42, 242) and has holding means for substrates, wherein the axes of the pylons are formed so as to be stationary relative to the longitudinal axis (40) of the evaporator array (10, 110, 110a), the evaporator array (10, 110, 110a) does not rotate about its longitudinal axis and the substrate carrier units (21, 121, 221, 22, 122, 222) do not rotate about the evaporator array (10, 110, 110a), and there is an angular offset of less than 10° between the longitudinal axis (40) and the second rotation axis (42, 242), and a geometrical configuration of the evaporator array (10, 110, 110a) and of the first (21, 121, 221) and the at least second substrate carrier unit (22, 122, 222) is provided such that coating can be carried out by means of the evaporator array (10) on substrates of the first (21, 121, 122) and of the at least second substrate carrier unit (22, 122, 222) with equal quality.

2. Device according to Claim 1, **characterized in that** the evaporator array (10) comprises at least one evaporator element (10a, 110, 110a) having a horizontal longitudinal extent (250) and a mirror-symmetrical emission characteristic with respect to a plane spanned by the longitudinal extent (250) and the longitudinal axis (40).

3. Device according to Claim 1 or 2, **characterized in that** at least one treatment source (31, 32) is provided, which is associated with the first (21, 121, 221) or optionally further substrate carrier units (22, 122, 222, 223, 224).

4. Device according to one of Claims 1 to 3, **characterized in that** the vacuum chamber (175) comprises
- a first sub-chamber (175a) having an opening in the wall 185 of the vacuum chamber (175),
- at least a second sub-chamber (180, 180a) which is associated with the first sub-chamber in the manner of a door and by which the opening can be closed in a vacuum-tight fashion,
wherein the evaporator array (110), the first (121) and the at least second substrate carrier unit (122) and the treatment source or treatment sources (31, 32) can be or are accommodated in the at least second sub-chamber.

5. Device according to Claim 4, **characterized in that** the second sub-chamber (180) can be positioned relative to the first sub-chamber (175a) by means of a swivel unit or by means of a displacement unit.

6. Device according to one of Claims 4 and 5, **characterized in that** the vacuum chamber (175) comprises a further sub-chamber (180a), which is formed in a similar fashion to the second sub-chamber (180) and is associated with the first sub-chamber in the manner of a door, and by which the opening of the first sub-chamber can be closed in a vacuum-tight fashion.

7. Device according to one of Claims 3 to 6, **characterized in that** at least one treatment source (31, 32) is formed as a plasma source having at least one electrode pair (31a/b, 32a/b, 130/131, 130/131a, 130'/132, 130'/132a) preferably containing at least one electrode in the form of a plate.

8. Device according to Claim 7, **characterized in that** at least one electrode (130, 130') of at least one electrode pair in the first sub-chamber and at least one associated back electrode (131, 131a, 132, 132a) of the at least one electrode pair is arranged in the second sub-chamber (180, 180a), wherein the back electrode (131, 131a, 132, 132a) can be positioned together with the second sub-chamber (180, 180a) relative to the first sub-chamber (175a).

9. Device according to one of Claims 3 to 8, **characterized in that** the dimensioning of the evaporator array (10) and optionally of the treatment sources (31, 32) comprises an extension of the evaporator array (10) and optionally of the treatment sources (31, 32) beyond the end regions of the substrate carrier units (21, 22) in order to compensate for spatial end effects.

10. Device according to one of the preceding claims, **characterized in that** a distance of the evaporator elements (10a) from one another can be adjusted in order to compensate for a decrease in a coating rate in the end regions of the evaporator array (10, 110, 110a) or of the substrate carrier units (21, 22).

11. Method for the vacuum coating of substrates, **characterized in that** the vacuum coating is carried out by means of a device according to one of the preceding claims.

12. Method according to Claim 11, **characterized in that** thermal evaporation of a metallic material, consisting of at least one of the members of the group consisting of aluminum, copper, tin, chromium, titanium, tantalum, gold, silver, rhodium, palladium and nickel, is carried out by means of the evaporator array (10, 110, 110a).

13. Method according to one of Claims 11 and 12, **characterized in that** treatment of the substrates with the aid of a glow discharge process is carried out by means of at least one of the treatment sources (31, 32).

14. Method according to one of Claims 11 to 13, **characterized in that** treatment of the substrates with the aid of a plasma CVD process is carried out by means of at least one of the treatment sources (31, 32).

## Revendications

1. Dispositif pour le revêtement sous vide de substrats dans une chambre à vide (175), comportant une batterie d'évaporateurs allongés (10, 110, 110a) comprenant un certain nombre d'éléments évaporateurs (10a, 210a) disposés le long d'un axe longitudinal vertical (40), et un premier dispositif support de substrats (21, 121, 221), affecté à la batterie d'évaporateurs (10, 110, 110a), comprenant un premier pylône, pouvant tourner autour d'un premier axe (41, 241), disposant de moyens de retenue pour des substrats, dans lequel on a entre l'axe longitudinal (40) et le premier axe de rotation (41, 241) un décalage angulaire inférieur à 10°, **caractérisé en ce qu'**au moins un deuxième dispositif support de substrats (22, 122, 222), affecté à la batterie d'évaporateurs (10, 110, 110a), est prévu avec un deuxième pylône, pouvant tourner autour d'un deuxième axe de rotation (42, 242), disposant de moyens de retenue pour des substrats, les axes des pylônes étant conçus fixes par rapport à l'axe longitudinal (40) de la batterie d'évaporateurs (10, 110, 110a), la batterie d'évaporateurs (10, 110, 110a) ne tournant pas autour de son axe longitudinal, et les dispositifs supports de substrats (21, 121, 221, 22, 122, 222) ne tournant pas autour de la batterie d'évaporateurs (10, 110, 110a), et un décalage angulaire inférieur à 10° existant entre l'axe longitudinal (40) et le deuxième axe longitudinal (42, 242), et une configuration géométrique de la batterie d'évaporateurs (10, 110, 110a), ainsi que du premier (21, 121, 221) et de l'au moins deuxième dispositif support de substrats (22, 122, 222) étant prévue de telle sorte que puisse être réalisé un revêtement, réalisé à l'aide de la batterie d'évaporateurs (10), de substrats du premier (21, 121, 122) et de l'au moins deuxième dispositif support de substrats (22, 122, 222), avec une qualité identique.

2. Dispositif selon la revendication 1, **caractérisé en ce que** la batterie d'évaporateurs (10) comprend au moins un élément évaporateur (10a, 110, 110a) présentant une extension longitudinale horizontale (250) et une caractéristique de rayonnement présentant une symétrie spéculaire par rapport à un plan passant par l'extension longitudinale (250) et l'axe longitudinal (40).

3. Dispositif selon la revendication 1 ou 2, **caractérisé en ce qu'**au moins une source de traitement (31, 32) est prévue, qui est affectée au premier (21, 121, 221) ou éventuellement à des dispositifs supplémentaires supports de substrats (22, 122, 222, 223, 224).

4. Dispositif selon l'une des revendications 1 à 3, **caractérisé en ce que** la chambre à vide (175) comprend
- une première chambre partielle (175a), comportant une ouverture dans la paroi (185) de la chambre à vide (175),
- au moins une deuxième chambre partielle (180, 180a), affectée à la manière d'une porte à la première chambre partielle, à l'aide de laquelle il est possible d'obturer l'ouverture d'une manière étanche au vide,
la batterie d'évaporateurs (110), le premier (121) et l'au moins deuxième dispositif support de substrats (122) et la source de traitement ou les sources de traitement (31, 32) pouvant être disposés ou étant disposés dans l'au moins deuxième chambre partielle.

5. Dispositif selon la revendication 4, **caractérisé en ce que** la deuxième chambre partielle (180) peut être positionnée par rapport à la première chambre partielle (175a) à l'aide d'un dispositif de pivotement ou à l'aide d'un dispositif de translation.

6. Dispositif selon l'une des revendications 4 à 5, **caractérisé en ce que** la chambre à vide (175) comprend une chambre partielle supplémentaire (180a), configurée d'une manière analogue à la deuxième chambre partielle (180), affectée à la manière d'une porte à la première chambre partielle, chambre partielle supplémentaire à l'aide de laquelle l'ouverture dans la première chambre partielle peut être obturée d'une manière étanche au vide.

7. Dispositif selon l'une des revendications 3 à 6, **caractérisé en ce qu'**au moins une source de traitement (31, 32) est configurée comme une source de plasma, avec au moins une paire d'électrodes (31a/b, 32a/b, 130/131, 130/131a, 130'/132, 130'/132a), contenant de préférence au moins une électrode en forme de plaque.

8. Dispositif selon la revendication 7, **caractérisé en ce qu'**au moins une électrode (130, 130') d'au moins une paire d'électrodes est disposée dans la première chambre partielle, et au moins une contre-électrode (131, 131a, 132, 132a) affectée, de la ou les paires d'électrodes, est disposée dans la deuxième chambre partielle (180, 180a), la contre-électrode (131, 131a, 132, 132a) pouvant, en même temps que la deuxième chambre partielle (180, 180a), être positionnée par rapport à la première chambre partielle (175a).

9. Dispositif selon l'une des revendications 3 à 8, **caractérisé en ce que** le dimensionnement de la batterie d'évaporateurs (10) ainsi qu'éventuellement des sources de traitement (31, 32) présente, pour la compensation des pertes aux extrémités, un surplomb, au-delà des zones d'extrémité des dispositifs supports de substrats (21, 22), de la batterie d'évaporateurs (10), ainsi qu'éventuellement des sources des traitements (31, 32).

10. Dispositif selon l'une des revendications précédentes, **caractérisé en ce qu'**un écartement entre les éléments évaporateurs (10a) peut être ajusté pour compenser une diminution de la vitesse de revêtement dans les zones d'extrémité de la batterie d'évaporateurs (10, 110, 110a) ou des dispositifs supports de substrats (21, 22).

11. Procédé de revêtement sous vide de substrats, **caractérisé en ce que** le revêtement sous vide est réalisé à l'aide d'un dispositif selon l'une des revendications précédentes.

12. Procédé selon la revendication 11, **caractérisé en ce qu'**on procède à l'aide de la batterie d'évaporateurs (10, 110, 110a) à une évaporation thermique d'un matériau métallique constitué d'au moins l'un des membres du groupe comprenant l'aluminium, le cuivre, l'étain, le chrome, le titane, le tantale, l'or, l'argent, le rhodium, le palladium ou le nickel.

13. Procédé selon l'une des revendications 11 ou 12, **caractérisé en ce qu'**on procède à l'aide d'au moins l'une des sources de traitement (31, 32) à un traitement des substrats à l'aide d'un procédé de décharge luminescente.

14. Procédé selon l'une des revendications 11 à 13, **caractérisé en ce qu'**on procède à l'aide d'au moins l'une des sources de traitement (31, 32) à un traitement des substrats à l'aide d'un procédé plasma-CVD.
